# EUROPÄISCHE PATENTSCHRIFT

(11) **EP 0 791 664 B1**
(45) Veröffentlichungstag und Bekanntmachung des Hinweises auf die Patenterteilung: **17.10.2001**
(21) Anmeldenummer: 97100450.2
(22) Anmeldetag: 14.01.1997
(51) Int. Cl.: C23C 14/20, C08L 101/00, C08L 27/16

(54) **Metallisierung von thermoplastischen Kunststoffen**
Metallisation of thermoplastics
Métallisation de matières thermoplastiques

(30) Priorität: 26.01.1996 DE 19602659
(43) Veröffentlichungstag der Anmeldung: 27.08.1997
(73) Patentinhaber: Ticona GmbH, 65451 Kelsterbach (DE)
(72) Erfinder: Scheckenbach, Helmut, Dr.-Ing., 63225 Langen (DE); Frank, Georg, Dr,, 72074 Tübingen (DE)

(56) Entgegenhaltungen:
- EP-A- 0 128 843
- EP-A- 0 283 914
- EP-A- 0 321 734
- EP-A- 0 414 097
- EP-A- 0 418 719

## Beschreibung

Die Erfindung betrifft metallisierte Formteile, die unter Verwendung von Polymer-Mischungen hergestellt sind, die mindestens ein thermoplastisches Polymer enthalten und die nicht homogen sind und mindestens zwei Phasen enthalten, und ein Verfahren zu deren Herstellung.

Die übliche Methode Kunststoffe zu metallisieren ist die elektrochemische Abscheidung von Metallen auf Kunststoffoberflächen. Hierbei wird in einem ersten Schritt die Kunststoffoberfläche chemisch oder mechanisch vorbehandelt, in einem zweiten Schritt ein diskontinuierlicher Primer aufgebracht, in einem dritten Schritt wird durch ein chemisches Verstärkungsbad, enthaltend ein Metallsalz und ein Reduktionsmittel, eine sehr dünne kontinuierliche metallische Schicht aufgebracht, und letztlich wird das so vorbehandelte Substrat zur galvanischen Metallisierung in eine wässrige Lösung eines Metallsalzes gegeben, um so eine dickere Schicht des Metalles zu erhalten. Die Primer-Beschichtung wird z. B. aufgebracht, indem man das vorbehandelte Substrat in eine saure Zinnsalz-Lösung gibt und den Gegenstand anschließend in einer wässrigen Edelmetallösung metallisiert. Beide Bäder können auch komprimiert werden.

Diese Methode ist ziemlich kompliziert und hat viele Einzelschritte, die sich durch heikle Prozeßbedingungen auszeichnen. Während die chemische beziehungsweise mechanische Vorbehandlung oft zur Beschädigung des Substrates führt, treten bei dem Aufbringen des Metall-Primers häufig Probleme wegen mangelnder Benetzbarkeit der Kunststoff-Oberfläche durch die Primer-Lösung auf. Die so erzeugte Primer-Schicht ist von schlechter Qualität, diskontinuierlich und schlecht haftend. Dieses und andere spezielle Metallisierungsverfahren sind beispielsweise in der US-A 4,590,115 beschrieben.

EP-A 0 414 097 beschreibt ebenfalls ein naßchemisches Verfahren zur elektrolytischen Metallisierung nichtmetallischer Substrate zum Zwecke der Herstellung gedruckter Schaltungen. Die Schrift bezieht sich auf eine Vereinfachung des Produktionsablaufs und die Erhöhung der Endqualität der Schaltungen. Das beschriebene Verfahren weist jedoch weiterhin die systembedingten Nachteile der naßchemischen Verfahren auf.

Ein weiteres naßchemisches Verfahren beschreibt EP-A 0 417 037. Hierbei wird ein Kunststoff-Gegenstand mit einer dünnen Edelmetallschicht beschichtet, wobei der Kunststoff einen Füllstoff enthält, der zu einer besseren Haftung der Edelmetallteilchen an der Oberfläche des zu metallisierenden Kunststoff-Gegenstandes führt und den Verlust an diesen Metallen durch Abscheiden im Bad minimiert. Als Füllstoffe dienen hierbei Metalloxide wie MnO, NiO, Cu₂O, SnO und Bi₂O₃. Nachteile dieser Füllstoffe sind jedoch ihre eingeschränkte chemische Beständigkeit sowie ihr Gewicht.

Ein grundsätzlicher Nachteil aller bekannten naßchemischen Verfahren besteht darin, daß relativ komplizierte Vorbehandlungssequenzen vorzusehen sind, bevor metallisiert wird, um die gewünschten Haftungswerte zu erreichen.

Diese Nachteile können überwunden werden durch Verwendung eines Vefahrens, bei dem die Metallisierung der Kunststoffe, speziell von Fluorpolymeren, durch Zersetzung metallorganischer Verbindungen in einem Plasma stattfindet (EP-A 0 321 734). Nachteilig ist jedoch die geringe Kontrolle über die lonenenergie, den umgebenden Gasdruck, die Substrattemperatur, usw. Ebenso ist es sehr schwierig, eine gute Kontrolle über den Energiestrahlfluß zu erhalten. Nachteilig sind ebenfalls die hohen Drücke (ca. 133 Pa), die benötigt werden, um eine fortdauernde Entladung zu gewährleisten. Diese Drücke sind zudem zu hoch, um die Verdampfung der Metallteilchen fortdauernd duchzuführen.

Diese Nachteile können überwunden werden durch Verwendung eines Verfahrens, das mit niederenergetischen Teilchen arbeitet und das in der EP-A 0 206 145 beschrieben ist. Nachteilig daran ist jedoch die mangelhafte Haftung der Metallisierung bei Verwendung bestimmter organischer Substrate wie z.B. Fluorpolymeren.

**EP-A-0 418 719 offenbart eine thermoplastische Formmasse enthaltend 10-94 Gew.-% eines Polyaryletherketons, Polyarylensulfids oder Polyetherimids oder deren Mischungen, 0-80 Gew.-% eines Polyethersulfons, 3-40 Gew.-% Glasfasern und 3-25 Gew.-% eines Erdalkalicarbonats sowie ein Verfahren zur Herstellung von Formkörpern hieraus und deren Metallisierung.**

Aufgabe der Erfindung war die Entwicklung von Formmassen auf Basis von **thermoplastischem Kunststoff enthaltend Fluorpolymer, Polyamid, Polycarbonat, Polyestern, Polyimid, flüssigkristallines Polymer (LCP), Polymethylmethacrylat, Polyphenylenoxid, Polyurethan, Silicone oder deren Mischungen**, die sich mittels Sputtern oder Bedampfen metallisieren lassen, wobei gegenüber den Ausgangspolymeren eine verbesserte Haftung der Metallschicht auf dem Polymersubstrat erzielt wird.

Überraschend wurde gefunden, daß bei der Verwendung von inhomogenen, mehrphasigen Polymermischungen, die neben einem thermoplastischen Polymeren **ausgewählt aus Fluorpolymer, Polyamid, Polycarbonat, Polyestern, Polyimid, flüssigkristallines Polymer (LCP), Polymethylmethacrylat, Polyphenylenoxid, Polyurethan oder Silicon** mindestens ein Polyarylensulfid, ein oxidiertes Polyarylensulfid, ein Polyimid, einen aromatischen Polyester oder ein Polyetherketon enthalten, metallisierte Kunststoffteile mit verbesserten Eigenschaften, insbesondere einer verbesserten Haftung der Metallschicht auf dem Kunststoffsubstrat, hergestellt werden können.

Die Erfindung betrifft somit metallisierte Kunststoffteile auf Basis von mehrphasigen Polymermischungen, **die durch Sputtern oder Bedampfen metallisiert wurden dadurch gekennzeichnet**, daß sie als Füllstoff mindestens ein Polyarylensulfid, ein oxidiertes Polyarylensulfid, ein Polyimid, einen aromatischen Polyester, ein Polyetherketon oder Mischungen von diesen enthalten.

Die Erfindung betrifft ferner ein Verfahren zur Herstellung haftfest metallisierter Kunststoffteile, wobei aus mehrphasigen Polymermischungen der obengenannten Zusammensetzung zunächst durch Formgebungsverfahren Formteile hergestellt werden und wobei die Formteile dann durch Bedampfen oder Sputtern metallisiert werden.

Erfindungsgemäß geeignete thermoplastische Polymere sind Fluorpolymere, Polyamide, Polycarbonate, Polyester, Polyimide, flüssigkristalline Polymere (LCP), Polymethylmethacrylate, Polyphenylenoxide, Polyurethane und Silikone. Bevorzugte thermoplastische Kunststoffe sind Fluorpolymere, insbesondere Polytetrafluorethylen (PTFE).

Die Metallisierung der Kunststoffteile erfolgt durch Bedampfen oder Sputtern. Die Metallisierung ist nicht auf ein bestimmtes Metall beschränkt. Die erzeugten Metallschichten können beispielsweise Kupfer, Silber, Aluminium, Gold, Titan, Eisen, Chrom oder Nickel enthalten.

Erfindungsgemäß geeignete thermoplastische Polymere werden beispielsweise beschrieben in Ullmann's Encyclopedia of Industrial Chemistry, 5. Auflage, VCH Verlagsgesellschaft mbH, Weinheim-New York 1992: organische Fluorpolymere, Volume A11, S. 393-430; Polyamide, Volume A21, S. 179-206; Polycarbonate, Volume A21, S.207-216; Polyester, Volume A21, S. 227-252; Polyimide, Volume A21, S. 253-273; Polymerblends, Volume A21, S. 274-305; Polymethylmethacrylate, Volume A21, S. 473-486; Polyphenylenoxide, Volume A21, S. 605-614; Polyurethane, Volume A21, S. 665-716 und Silikone, Volume A24, S.57-95, worauf Bezug genommen wird.

Polyarylensulfide, die auch Polyarylenthioether genannt werden, sind Polymere, die mindestens eine Arylensulfid-Einheit (-A-S-; A = Arylen-Rest, S = Schwefel) enthalten. Arylene sind beispielsweise Phenylen, Biphenylen (-C₆H₄-C₆H₄-), Naphthylen, die ein- oder mehrfach substituiert sein können. Substituenten sind z.B. geradkettige, cyclische oder verzweigte C₁-C₂₀-Kohlenwasserstoffreste, wie C₁-C₁₀-Alkylreste, z. B. Methyl, Ethyl, n-Propyl, iso-Propyl, n-Butyl, t-Butyl oder n-Hexyl, oder C₆-C₁₄-Arylreste, z. B. Phenyl oder Naphtyl; Halogene, Sulfonsäure-, Amino-, Nitro-, Cyano-, Hydroxy- oder Carboxylgruppen. Besonders geeignet ist Polyphenylensulfid (PPS) als Mischungsbestandteil B).

Polyarylensulfide, insbesondere Polyphenylensulfid, lassen sich auf Grundlage der Reaktion von dihalogenierten Aromaten mit Natriumsulfid nach EDMONDS und HILL herstellen. Polyarylensulfide und deren Herstellung sind in "Ullmann's Encyclopedia of Industrial Chemistry, Volume A21, B. Elvers, S. Hawkins und G. Schulz (Eds.), VCH, Weinheim-New York 1992, S. 463-472 beschrieben, worauf Bezug genommen wird. Die Synthese von sulfongruppenhaltigen Polyarylensulfiden ist in Chimia 28(9), (1974) 567 beschrieben, worauf ebenfalls Bezug genommen wird.

Oxidierte Polyarylensulfide sind lineare und verzweigte Polyarylene, deren Schwefelgruppen teilweise oder vollständig in Sulfoxid- und/oder Sulfongruppen überführt worden sind. Oxidierte Polyarylensulfide und deren Herstellung werden in den deutschen Patentanmeldungen DE 43 14 737 und DE 43 14 738 beschrieben, worauf Bezug genommen wird. Oxidierte Polyarylensulfide sind beispielsweise Polyarylensulfoxide, Polyarylensulfone, Polyarylensulfid-sulfoxide, Polyarylensulfid-sulfoxid-sulfone, Polyarylensulfid-sulfone und Polyarylensulfoxid-sulfone. Besonders bevorzugte Polyarylensulfone oder Polyarylensulfid-sulfoxid-sulfone sind oxidierte Polyarylensulfide, bei denen mindestens 40%, bevorzugt mindestens 60%, der Schwefelbrücken in Sulfongruppen umgewandelt sind. Bevorzugte Polyarylensulfone sind Polyphenylensulfone, insbesondere Polyphenylensulfone mit mindestens 40%, bevorzugt mindestens 60%, Sulfongruppen. Oxidierte Polyarylensulfide sind besonders wärmebeständig und unter den Bedingungen einer thermoplastischen Verarbeitung sehr stabil. Die oxidierten Polyarylensulfide verhalten sich wie Füllstoffe in den thermoplastischen Kunststoffen.

Polyimide werden beispielsweise beschrieben in Ullmann's Encyclopedia of Industrial Chemistry, Volume A21, VCH Verlagsgesellschaft mbH, Weinheim-New York 1992, S. 253-272, worauf Bezug genommen wird. Die Polyimide umfassen die thermoplastischen Polyimide als auch durch Polykondensation oder Polyaddition erhältliche Polyimide.

Besonders geeignet ist ein Polyimid, charakterisiert durch die Formel

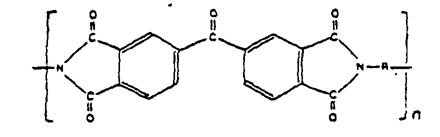

Das Polyimid ist unter dem Markennamen P84 von der Lenzing AG, Lenzing, Österreich erhältlich.

Lineare aromatische Polyester werden beispielsweise in Ullmann's Encyclopedia of Industrial Chemistry, Volume A21, VCH Verlagsgesellschaft mbH, Weinheim-New York 1992, S.227-251, beschrieben, worauf Bezug genommen wird.

Besonders geeignet ist ein Polyester mit Oxybenzoyl-Einheiten, -O-C₆H₄-CO-. Der Polyester ist unter dem Markennamen Sumika Super E101S bei Sumitomo Chemical Co., Ltd, Tokio, Japan, bzw. Ekonol bei The Carborundum Company, Sanborn, NY, USA, erhältlich.

Als Polyetherketon eignet sich besonders ein Polyetheretherketon, das unter der Bezeichnung Victrex PEEK 150XF als feingemahlenes Material mit einer mittleren Korngröße von ca. 30 *µ*m bei der Firma Victrex Deutschland GmbH, Hofheim, Deutschland, erhältlich ist.

Von den Mischungsbestandteilen B), die für die verbesserte Metallisierbarkeit verantwortlich sind, sind die oxidierten Polyarylensulfide besonders geeignet, da sie neben der Verbesserung der Metallisierbarkeit noch zusätzlich eine überragende Chemikalienbeständigkeit aufweisen. Fluorpolymere beispielsweise behalten durch die Zugabe von oxidierten Polyphenylensulfiden - speziell Polyphenylensulfon - weitgehend ihre universelle Chemikalienbeständigkeit bei.

Die Mischungsbestandteile B) werden vorteilhaft als Pulver eingesetzt. Die mittlere Korngröße (D₅₀-Wert) der Pulver liegt im allgemeinen im Bereich von 0,3×10⁻⁶ bis 500×10⁻⁶ m, vorzugsweise 1×10⁻⁶ bis 100×10⁻⁶ m und insbesondere 5×10⁻⁶ bis 50×10⁻⁶ m. Für eine besonders gute Haftung der Metallschicht an der Substratoberfläche ist eine möglichst geringe Korngröße, insbesondere der gegebenenfalls nicht schmelzbaren Mischungsbestandteile B) anzustreben.

Der Anteil der Mischungsbestandteile B) liegt im Bereich von 1 bis 99 Gewichtsprozent, vorteilhaft im Bereich von 1 bis 30 Gewichtsprozent, insbesondere von 1 bis 20 Gewichtsprozent, die Angaben in Gewichtsprozent sind dabei jeweils bezogen auf das Gesamtgewicht der Polymermischung. Ein Anteil im Bereich von 5 bis 15 Gewichtsprozent ist erfindungsgemäß besonders bevorzugt.

Die Polymermischungen gemäß der Erfindung können übliche Additive enthalten, wie thermische Stabilisatoren, UV-Stabilisatoren, Antistatika, Flammschutzmittel, Farbstoffe, Pigmente, anorganische und/oder organische Füllstoffe sowie Gleitmittelzusätze wie Molybdändisulfid oder Graphit.

Die Mischungen gemäß der Erfindung werden im allgemeinen aus den Einzelkomponenten in hierfür geeigneten Mischern hergestellt, anschließend nach bekannten Verfahren (z.B. Spritzguß, Heißpressen, Extrusion, Blasformen, Sintern) in dafür geeigneten Apparaturen bei Temperaturen von 150° C bis 450° C, vorzugsweise 200 bis 400° C, zu Formkörpern (Substraten) verarbeitet und dann metallisiert.

Die erfindungsgemäßen metallisierten Kunststoff-Gegenstände kommen in den verschiedenartigsten Industriezweigen, bei denen man metallische Oberflächen benötigt, zur Anwendung, z. B. in der Automobilindustrie, z. B. für Rahmen von Anzeigeinstrumenten, Radios, Türgriffen, für Fensterheber, Heizungsgrills, Armaturenbrettknöpfe, Scheinwerferreflektoren, Rücklichter etc., ferner in der Radio-, TV- und Elektronikindustrie, insbesondere für gedruckte Schaltungen, sowohl in Mehrschicht- wie auch Hybrid-Schaltungen und als Chip-Träger und in EMI-Shielding Installationen, etc.; außerdem in der Luftfahrtindustrie, in der Dental- und Medizinalindustrie, in der optischen Industrie, beispielsweise bei der Spiegelherstellung, sowie bei Haushaltsgegenständen.

### Ausführungsbeispiele:

### Herstellung von Polyphenylensulfon (PPSO₂):

63 kg Polyphenylensulfid-Pulver (d₅₀-Wert: 20 *µ*m) mit einer T_{g} von 94° C und einem Tₘ von 290° C wurden in 219 I Eisessig bei 50°C vorgelegt, 1,2 I konz. Schwefelsäure zugegeben und 91 kg Wasserstoffperoxid (50%) über 3 h zugetropft, wobei sich die Temperatur auf 60 - 65°C erhöhte. Nach einer Nachrührzeit von 2 h bei 65°C und 1 h bei 80°C wurde die Reaktionslösung abgekühlt, bei 50°C abgesaugt, mit Wasser gewaschen und getrocknet. Ausbeute: 70 kg; DSC-Daten: T_{g}: 352°C Tₘ: 520°C (Zersetzung)
Elementaranalyse: (C₆H₄SO₂)ₙ
C: 55,6%, H: 3,2%, S: 24,6%, O: 16,0%.

Dies entspricht einem Schwefel-Oxidationsgrad im Polymer von etwa 65%, bezogen auf 100 % der theoretisch möglichen Sauerstoffaufnahme.

Im Rahmen der Beispiele wurden weiterhin folgende Polymere verwendet:

®Sumika Super E 101S ein linearer aromatischer Polyester (Produktform: Pulver) der Sumitomo Chemical Co. Ltd, Tokio, Japan. Produkteigenschaften und Verarbeitungshinweise sind im Datenblatt "Sumika Super" der Sumitomo Chemical Co. Ltd dokumentiert.

P 84 ein Polyimid (Produktform: Pulver) der Lenzing AG, Lenzing, Österreich. Produkteigenschaften und Verarbeitungshinweise sind im Datenblatt "Lenzing P 84" der Lenzing AG dokumentiert.

®Fortron 0205 B4/20, ein Polyphenylensulfid (Produktform: Pulver) der Hoechst AG, Frankfurt a.M., BR Deutschland. Produkteigenschaften und Verarbeitungshinweise sind im Datenblatt "Fortron" der Hoechst AG dokumentiert.

Gemahlene unbeschlichtete Textilglasfaser bestehend aus Einzelfilamenten unterschiedlicher Länge (mittlere Faserlänge: 60 *µ*m, Faserdurchmesser: 14 *µ*m)

®Hostaflon TF 1750, ein Polytetrafluorethylen (Produktform: Pulver) der Hoechst AG, Frankfurt a.M., BR Deutschland. Produkteigenschaften und Verarbeitungshinweise sind im Datenblatt "Hostaflon" der Hoechst AG dokumentiert.

Hostaflon PFA 6515 ein Fluorthermoplast (Produktform: Pulver) der Hoechst AG, Frankfurt a.M., BR Deutschland. Produkteigenschaften und Verarbeitungshinweise sind im Datenblatt "Hostaflon" der Hoechst AG dokumentiert.

Polybutylenterephthalat (PBT) mit einem MVI (250° C/2,16 kg) von 38 cm³/10 min. Produktform: Granulat.

®Vectra A950, ein flüssigkristallines Polymer (Produktform: Granulat) der Hoechst AG, Frankfurt a.M., BR Deutschland. Produkteigenschaften und Verarbeitungshinweise sind im Datenblatt "Vectra" der Hoechst AG dokumentiert.

®Ultem 1000 ein Polyetherimid (Produktform: Granulat) der General Electric Plastics GmbH, Rüsselsheim, BR Deutschland. Produkteigenschaften und Verarbeitungs-hinweise sind im Datenblatt "Ultem" der General Electric Plastics dokumentiert.

PEEK 450 G ein Polyetheretherketon (Produktform: Granulat) der Victrex Deutschland GmbH, Hofheim, BR Deutschland. Produkteigenschaften und Verarbeitungshinweise sind in der Broschüre ®"Victrex PEEK" der ICI Materials, Middlesbrough, England, dokumentiert.

®Torlon 4203 L ein Polyamidimid (Produktform: Granulat) der Amoco Chemcial Deutschland GmbH, Düsseldorf, BR Deutschland. Produkteigenschaften und Verarbeitungshinweise sind im Datenblatt "Amoco Performance Products" der Amoco dokumentiert.

PEEK 150XF, ein feingemahlenes Polyetheretherketon mit einer mittleren Korngröße von etwa 30 *µ*m, das bei der Firma Victrex Deutschland GmbH, Hofheim, Deutschland, erhältlich ist.

### Herstellung der Compounds:

Die Granulate wurden auf einer Labormühle des Typs ZM 1 der Fa. Retsch, Haan, BR Deutschland, gemahlen. Anschließend wurden die Mischungen gemäß den Rezepturen der Tabellen 1 und 2 gemischt. Diese Mischungen wurden getrocknet und auf einer Presse des Typs Polystat 200 S der Fa. Schwabenthan, Berlin, BR Deutschland zu Probekörpern verarbeitet (Probekörperform: Runde Scheibe, Durchmesser: 60 mm, Dicke: 4 mm. Die Preßtemperaturen sind jeweils vor den Tabellen angegeben, die Preßzeit betrug einheitlich 15 min).

### Metallisierung der Probekörper:

Nach der Herstellung wurden die Probekörper in einer kommerziellen Sputteranlage der Fa. Leyhold Heraeus Z 700 metallisiert. Zur Metallisierung wurden die Probekörper in der Anlage auf eine Halterung in einem Abstand von 5 cm vom Sputtertarget simultan montiert, um für alle Probekörper die identischen Versuchsparameter zu gewährleisten. Für die Metallisierung wurde Kupfer mit elektrochemischer Reinheit verwendet. Die Kammer wurde dann auf ein Vakuum von ca. 10⁻⁵ mbar evakuiert und im Anschluß wurden die Proben mit Sauerstoff bei einem Druck von 5 x 10⁻³ mbar 15 Minuten beglimmt. Dabei wurde eine Spannung von 45 V an die Proben angelegt, die Plasmaleistung war 1 kW. Nach der Beglimmung wurden die Proben sofort mit Cu beschichtet, wobei Ar als Sputtergas verwendet wurde. Die Leistung betrug 1 kW DC (Direct Current = Gleichstrom). Damit eine gleichmäßige Beschichtung gewährleistet ist, wurden die Proben auf ihrem Halter in der Kammer mit einer Geschwindigkeit von 1/3 Umdrehungen/Minute rotiert. Die Dicke der aufgesputterten Cu-Schicht betrug 240 nm. Nach Beendigung der Metallisierung wurden die Proben aus dem Vakuum entnommen und die Haftfestigkeit bestimmt.

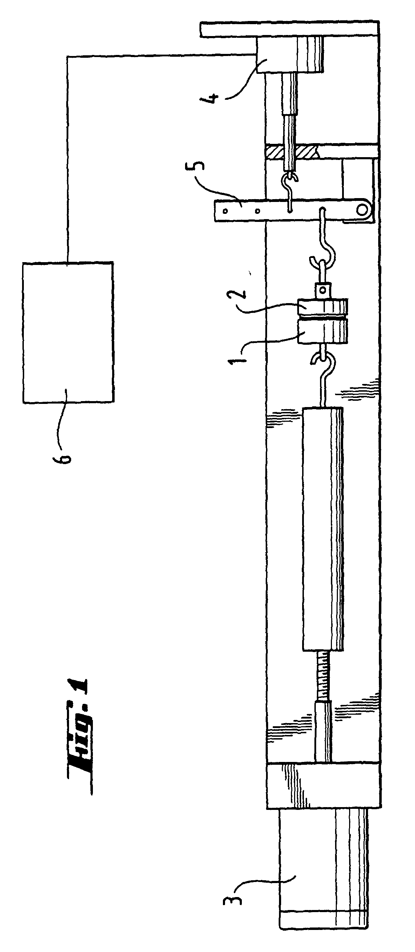

Die Bestimmung der Haftfestigkeit wurde in einer Eigenbauapparatur durchgeführt, deren Aufbau in der **Figur 1** zu sehen ist. Im einzelnen zeigt die Figur 1 einen Stempel 1 bekannter Fläche, der auf die metallisierte Fläche der Probe 2 geklebt ist. Die Haftfestigkeit des Klebers ist bekannt und stets größer als die Werte, die in der Apparatur für die Haftung der Metallschichten in Tabelle 1 und 2 ermittelt wurden. Mit Hilfe des Steppermotors 3 wird auf den Stempel 1 eine Kraft ausgeübt, die über den Hebel 5 auf die Kraftaufnehmerdose 4 (Burster, Typ 8523 der Fa. Burster Präzisionsmeßtechnik, Gernsbach, BR Deutschland) übertragen und dort gemessen wird. Die Kraftaufnehmerdose 4 liefert als Ausgangssignal eine Spannung, die mit Hilfe eines elektronischen Anzeigegerätes 5 (Keithley 197 Multimeter) digital aufgezeichnet wird. Sobald der Stempel 1 die Metalliserungschicht von der Probe 2 abreißt, geht die Spannung wieder auf Null zurück, so daß aus der Maximalspannung die Abrißkraft berechnet werden kann. Die Eichung der Apparatur erfolgte mit Proben, deren Abrißkräfte aus unabhängigen Experimenten bekannt waren. Für die unten stehenden Daten ist der Absolutwert der Abrißkraft nicht von so entscheidender Bedeutung, wichtig ist der jeweilige relative Vergleich zwischen der Werten der reinen thermoplastischen Polymeren A) im Vergleich mit dem jeweiligen Compound mit Mischungskomponente B).

### Vergleichsbeispiel V1, Beispiele 1 bis 9:

In der nachfolgenden Tabelle 1 sind die Polymerzusammensetzungen im einzelnen angegeben sowie die an diesen gemessenen Abreißkräfte. Als PPSO₂ wurde das Polymer verwendet, das einen Oxidationsgrad von 65 % besitzt und dessen Herstellung vorstehend beschrieben wurde. Die Preßtemperatur bei der Herstellung der Prüfkörper betrug einheitlich 375°C.

**Tabelle 1**

| Beispiel | Polymermischung | Sputtermedium | Abreißkraft [N/cm ² ] | Abrißfläche [%] | Haftung [N/cm ² ] |
|---|---|---|---|---|---|
| V1 | Hostaflon | 240 nm Cu | 89 | 96 | 92 |
| | TF 1750 | | | | |
| 1 | 90 % Hostaflon | 240 nm Cu | 231 | 97 | 237 |
| | TF 1750 | | | | |
| | 10 % Glasfaser | | | | |
| 2 | 90 % Hostaflon | 240 nm Cu | 564 | 94 | 603 |
| | TF 1750 | | | | |
| | 10 % PPSO ₂ | | | | |
| 3 | 90 % Hostaflon | 100 nm Ti | 480 | 77 | 637 |
| | TF 1750 | 240 nm Cu | | | |
| | 10 % PPSO ₂ | | | | |
| 4 | 90 % Hostaflon | 10 nm TiO | 411 | 97 | 426 |
| | TF 1750 | 100 nm Ti | | | |
| | 10 % PPSO ₂ | 240 nm Cu | | | |
| 5 | 90 % Hostaflon | 200 nm Cu | 595 | 96 | 616 |
| | TF 1750 | | | | |
| | 10 % P 84 | | | | |
| 6 | 90 % Hostaflon | 200 nm Cu | 519 | 99 | 521 |
| | TF 1750 | | | | |
| | 10 % Sumika Super | | | | |
| | E 101 S | | | | |
| 7 | 90 % Hostaflon | 240 nm Cu | 488 | 96 | 508 |
| | TF 1750 | | | | |
| | 10 % Fortron 0205 | | | | |
| | B4/20 | | | | |
| 8 | 90 % Hostaflon | 240 nm Cu | 581 | 97 | 599 |
| | TF 1750 | | | | |
| | 5 % PPSO ₂ | | | | |
| | 5 % P 84 | | | | |
| 9 | 90 % Hostaflon | 240 nm Cu | 543 | 98 | 554 |
| | TF 1750 | | | | |
| | 5 % PPSO ₂ | | | | |
| | 5 % Sumika Super | | | | |
| | E 101S | | | | |

### Vergleichsbeispiel V2, Beispiel 10:

In Tabelle 2 sind weitere Polymerzusammensetzungen angegeben sowie an diesen gemessene Abreißkräfte. Die Preßtemperatur bei der Herstellung der Prüfkörper betrug 375°C.

**Tabelle 2**

| Beispiel | Polymermischung | Sputtermedium | Abreißkraft [N/cm ² ] | Abrißfläche [%] | Haftung [N/cm ² ] |
|---|---|---|---|---|---|
| V2 | Hostaflon | 240 nm Cu | 90 | 95 | 95 |
| | PFA 6516 | | | | |
| 10 | 90 % Hostaflon | 240 nm Cu | 622 | 97 | 642 |
| | PFA 6516 | | | | |
| | 10 % PPSO ₂ | | | | |

### Vergleichsbeispiel V3, Beispiele 11 und 12:

In Tabelle 3 sind weitere Polymerzusammensetzungen angegeben sowie an diesen gemessene Abreißkräfte. Die Preßtemperatur bei der Herstellung der Prüfkörper betrug 250°C.

**Tabelle 3**

| Beispiel | Polymermischung | Sputtermedium | Abreißkraft [N/cm²] | Abrißfläche [%] | Haftung [N/cm²] |
|---|---|---|---|---|---|
| V3 | PBT | 240 nm Cu | 3139 | 92 | 3414 |
| 11 | 95 % PBT | 240 nm Cu | 3438 | 94 | 3656 |
| | 5 % PPSO₂ | | | | |
| 12 | 90 % PBT | 240 nm Cu | 3620 | 95 | 3834 |
| | 10 % PPSO₂ | | | | |

### Vergleichsbeispiel V4, Beispiel 13:

In Tabelle 4 sind weitere Polymerzusammensetzungen angegeben sowie an diesen gemessene Abreißkräfte. Die Preßtemperatur bei der Herstellung der Prüfkörper betrug 300°C.

**Tabelle 4**

| Beispiel | Polymermischung | Sputtermedium | Abreißkraft [N/cm²] | Abrißfläche [%] | Haftung [N/cm²] |
|---|---|---|---|---|---|
| V4 | Vectra A950 | 240 nm Cu | 532 | 92 | 570 |
| 13 | 90 % Vectra A950 | 240 nm Cu | 852 | 97 | 878 |
| | 10 % PPSO₂ | | | | |

### Vergleichsbeispiel V5, Beispiel 14 und 15:

In Tabelle 5 sind weitere Polymerzusammensetzungen angegeben sowie an diesen gemessene Abreißkräfte. Die Preßtemperatur bei der Herstellung der Prüfkörper betrug 380°C.

**Tabelle 5**

| Beispiel | Polymermischung | Sputtermedium | Abreißkraft [N/cm²] | Abrißfläche [%] | Haftung [N/cm²] |
|---|---|---|---|---|---|
| V5 | Ultem 1000 | 240 nm Cu | 1976 | 97 | 2025 |
| 14 | 90 % Ultem 1000 | 240 nm Cu | 2180 | 100 | 2180 |
| | 10 % PPSO₂ | | | | |
| 15 | 90 % Ultem 1000 | 240 nm Cu | 2903 | 98 | 2965 |
| | 10 % P84 | | | | |

### Vergleichsbeispiel V7, Beispiele 17 und 18:

In Tabelle 7 sind weitere Polymerzusammensetzungen angegeben sowie an diesen gemessene Abreißkräfte. Die Preßtemperatur bei der Herstellung der Prüfkörper betrug 380°C.

**Tabelle 7**

| Beispiel | Polymermischung | Sputtermedium | Abreißkraft [N/cm²] | Abrißfläche [%] | Haftung [N/cm²] |
|---|---|---|---|---|---|
| V7 | Victrex PEEK 450G | 240 nm Cu | 2340 | 87 | 2613 |
| 17 | 90 % Victrex PEEK | 240 nm Cu | 4194 | 100 | 4194 |
| | 450 G | | | | |
| | 10 % PPSO₂ | | | | |
| 18 | 90 % Victrex PPEK | 240 nm Cu | 2917 | 97 | 3010 |
| | 450 G | | | | |
| | 10 % P84 | | | | |

### Vergleichsbeispiel V8, Beispiele 19 und 20:

In Tabelle 8 sind weitere Polymerzusammensetzungen angegeben sowie an diesen gemessene Abreißkräfte. Die Preßtemperatur bei der Herstellung der Prüfkörper betrug 260°C.

**Tabelle 8**

| Beispiel | Polymermischung | Sputtermedium | Abreißkraft [N/cm²] | Abrißfläche [%] | Haftung [N/cm²] |
|---|---|---|---|---|---|
| V8 | Torlon 4203L | 240 nm Cu | 1419 | 80 | 1725 |
| 19 | 90 % Torlon 4203L | 240 nm Cu | 2782 | 99 | 2799 |
| | 10 % PPSO₂ | | | | |
| 20 | 90 % Torlon 4203L | 240 nm Cu | 2221 | 99 | 2261 |
| | 10 % P84 | | | | |

### Vergleichsbeispiel V11, Beispiele 22, 23 und 25:

In Tabelle 10 sind weitere Polymerzusammensetzungen angegeben sowie an diesen gemessene Abreißkräfte. Die Preßtemperatur bei der Herstellung der Prüfkörper betrug 375°C.

**Tabelle 10**

| Beispiel | Polymermischung | Sputtermedium | Abreißkraft [N/cm²] | Abrißfläche [%] | Haftung [N/cm²] |
|---|---|---|---|---|---|
| V11 | Hostaflon TF 1750 | 240 nm Cu | 89 | 96 | 92 |
| 23 | 90 % Hostaflon | 240 nm Cu | 406 | 100 | 406 |
| | TF 1750 | | | | |
| | 5 % Victrex PEEK | | | | |
| | 150XF | | | | |
| | 5 % PPSO₂ | | | | |
| 24 | 90 % Hostaflon | 240 nm Cu | 693 | 100 | 693 |
| | TF 1750 | | | | |
| | 10 % Victrex PEEK | | | | |
| | 150XF | | | | |
| 25 | 80 % Hostaflon | 240 nm Cu | 977 | 100 | 977 |
| | TF 1750 | | | | |
| | 20 % Victrex PEEK | | | | |
| | 150XF | | | | |

### Beispiele 26 bis 29:

Im Rahmen der Beispiele 26 bis 29 wird gezeigt, daß der Einfluß der Vorbehandlung der Proben, die in den Vergleichsbeispielen V1 bis V10 und in den Beispielen 1 bis 25 mit Sauerstoff durchgeführt wurde, nur einen sehr geringen Einfluß auf die Qualität der Haftung des Kupfers auf den Prüfkörpern hat. In Tabelle 11 sind die Vergleiche der unterschiedlichen Haftungen von Kupfer auf PTFE/PPSO₂ nach unterschiedlichen Vorbehandlungen vor der Metallisierung dargestellt. Die experimentellen Details sind mit denen aus Beispiel 1 identisch. Die Preßtemperatur bei der Herstellung der Prüfkörper betrug 375 °C.

**Tabelle 11**

| Beispiel | Polymermischung | Vorbehandlungsgas | Sputtermedium | Abreißkraft [N/cm²] | Abrißfläche [%] | Haftung [N/cm²] |
|---|---|---|---|---|---|---|
| 26 | 90 % | Luft | 240 nm Cu | 525 | 93 | 565 |
| | Hostaflon | | | | | |
| | TF 1750 | | | | | |
| | 10 % | | | | | |
| | PPSO₂ | | | | | |
| 27 | 90 % | O₂ | 240 nm Cu | 564 | 94 | 603 |
| | Hostaflon | | | | | |
| | TF 1750 | | | | | |
| | 10 % | | | | | |
| | PPSO₂ | | | | | |
| 28 | 90% | NH₃ | 240 nm Cu | 501 | 96 | 522 |
| | Hostaflon | | | | | |
| | TF 1750 | | | | | |
| | 10 % | | | | | |
| | PPSO₂ | | | | | |
| 29 | 90 % | CF₄ | 240 nm Cu | 551 | 94 | 584 |
| | Hostaflon | | | | | |
| | TF 1750 | | | | | |
| | 10 % | | | | | |
| | PPSO₂ | | | | | |

## Patentansprüche

1. Metallisierte Kunststoffteile auf Basis von mehrphasigen Polymermischungen, die durch Sputtern oder Bedampfen metallisiert wurden, **dadurch gekennzeichnet, daß** sie als thermoplastische Polymere der Komponente A) Fluorpolymere, Polyamide, Polycarbonate, Polyester, Polyimide, flüssigkristalline Polymere (LCP), Polymethylmethacrylate, Polyphenylenoxide, Polyurethane oder Silikone enthalten und als Füllstoff B) mindestens ein Polyarylensulfid, ein oxidiertes Polyarylensulfid, ein Polyimid, einen aromatischen Polyester oder ein Polyetherketon.

2. Metallisierte Kunststoffteile nach Anspruch 1, **dadurch gekennzeichnet, daß** sie als thermoplastische Polymere der Komponente A) Polymere enthalten, die einen Schmelzpunkt oberhalb von 100° C besitzen.

3. Metallisierte Kunststoffteile nach Anspruch 1 oder 2, **dadurch gekennzeichnet, daß** sie als thermoplastische Polymere der Komponente A) Polytetrafluorethylen (PTFE) enthalten.

4. Metallisierte Kunststoffteile nach einem der Ansprüche 1 bis 3, **dadurch gekennzeichnet, daß** der Füllstoff der Komponente B) als Pulver mit einer mittleren Korngröße im Bereich von 0,3×10⁻⁶ bis 500×10⁻⁶ m eingesetzt wird und nicht schmelzbar ist.

5. Metallisierte Kunststoffteile nach einem der Ansprüche 1 bis 4, **dadurch gekennzeichnet, daß** sie als Füllstoff der Komponente 8) oxidiertes Polyarylensulfid enthalten.

6. Metallisierte Kunststoffteile nach einem der Ansprüche 1 bis 5, **dadurch gekennzeichnet, daß** die Metallisierung Kupfer, Silber, Aluminium, Gold, Titan, Eisen, Chrom oder Nickel oder Mischungen oder Legierungen von diesen enthält.

7. Verfahren zur Herstellung von Kunststoffteilen nach einem der Ansprüche 1 bis 6, **dadurch gekennzeichnet, daß** Mischungen aus den Einzelkomponenten hergestellt werden, daß anschließend durch Spritzguß oder Heißpressen oder Extrusion oder Blasformen oder Sintern bei Temperaturen von 150 bis 450 °C, vorzugsweise 200 bis 400 °C, die Mischungen zu Formteilen verarbeitet werden und daß dann die Formteile durch Bedampfen oder Sputtern metallisiert werden.

8. Verfahren nach Anspruch 7, **dadurch gekennzeichnet, daß** Mischungen aus den Einzelkomponenten hergestellt werden, bei denen der Anteil der Mischungskomponente B) im Bereich von 1 bis 99 Gewichtsprozent, vorzugsweise im Bereich von 1 bis 30 Gewichtsprozent, insbesondere von 1 bis 20 Gewichtsprozent liegt, bezogen auf das Gesamtgewicht der Polymermischung.

9. Verfahren nach Anspruch 8, **dadurch gekennzeichnet, daß** der Anteil von B im Bereich von 5 bis 15 Gewichtsprozent liegt.

10. Verwendung von metallisierten Formteilen nach einem der Ansprüche 1 bis 6, in der Automobilindustrie zur Herstellung von Rahmen von Anzeigeinstrumenten und Radios, von Türgriffen, von Fensterhebern, von Heizungsgrills, von Armaturenbrettknöpfen und von Scheinwerferreflektoren, in der Radio-, TV- und Elektronikindustrie für gedruckte Schaltungen, als Chip-Träger und in EMI-Shielding Installationen, in der Luftfahrtindustrie, in der Dental- und Medizinalindustrie, in der optischen Industrie, zur Herstellung von Spiegeln sowie zur Herstellung von Haushaltsgegenständen und Spielzeug.

## Claims

1. A metallized plastics part based on multiphase polymer mixtures and metallized by sputtering or vapor deposition, comprising as thermoplastic polymers of component A) fluoropolymers, polyamides, polycarbonates, polyesters, polyimides, liquid-crystalline polymers (LCPs), polymethyl methacrylates, polyphenylene oxides, polyurethanes or silicones and as filler B) at least one polyarylene sulfide, oxidized polyarylene sulfide, polyimide, aromatic polyester or polyether ketone.

2. A metallized plastics part as claimed in claim 1, wherein the thermoplastic polymers of component A) are polymers having a melting point of more than 100°C.

3. A metallized plastics part as claimed in claim 1 or 2, wherein the thermoplastic polymers of component A) comprise polytetrafluoroethylene (PTFE).

4. A metallized plastics part as claimed in any of claims 1 to 3, wherein the filler of component B) is employed as powder having a mean particle size in the range from 0.3 x 10⁻⁶ to 500 x 10⁻⁶ m and is not meltable.

5. A metallized plastics part as claimed in any of claims 1 to 4, wherein the filler of component B) comprises oxidized polyarylene sulfide.

6. A metallized plastics part as claimed in any of claims 1 to 5, wherein the metallization coat comprises copper, silver, aluminum, gold, titanium, iron, chromium or nickel, or mixtures or alloys thereof.

7. A process for preparing a plastics part as claimed in any of claims 1 to 6, which comprises preparing mixtures of the individual components, subsequently processing the mixtures by injection molding or hot pressing or extrusion or blow molding or sintering to form moldings at temperatures from 150 to 450°C, preferably from 200 to 400°C, and then metallizing the moldings by vapor deposition or sputtering.

8. The process as claimed in claim 7, wherein mixtures of the individual components are prepared in which the proportion of the mixture component B) is in the range from 1 to 99 percent by weight, preferably from 1 to 30 percent by weight, in particular from 1 to 20 percent by weight, based on the overall weight of the polymer mixture.

9. The process as claimed in claim 8, wherein the proportion of B) is in the range from 5 to 15 percent by weight.

10. The use of a metallized molding as claimed in any of claims 1 to 6 in the automotive industry, for producing surrounds of display instruments and radios, door handles, window levers, heating grilles, dashboard buttons and headlamp reflectors, in the radio, TV and electronics industry for printed circuits, as chip supports and in EMI shielding installations, in the aircraft industry, in dentistry and medicine, in the optics industry, for producing mirrors, and also for producing household articles and toys.

## Revendications

1. Pièces en matière plastique métallisées, à base de mélanges de polymères polyphasiques, qui ont été métallisées par pulvérisation cathodique ou vaporisation, **caractérisées en ce qu'**elles contiennent en tant que polymères thermoplastiques du composant A) des polymères fluorés, des polyamides, des polycarbonates, des polyesters, des polyimides, des polymères de type cristal liquide (LCP), des poly(méthacrylate de méthyle)s, des polyoxyphénylènes, des polyuréthannes ou des silicones, et, en tant que charge B), au moins un poly(sulfure d'arylène), un poly(sulfure d'arylène) oxydé, un polyimide, un polyester aromatique ou une polyéther-cétone.

2. Pièces en matière plastique métallisées selon la revendication 1, **caractérisées en ce qu'**elles contiennent, en tant que polymères thermoplastiques du composant A), des polymères qui ont un point de fusion supérieur à 100°C.

3. Pièces en matière plastique métallisées selon la revendication 1 ou 2, **caractérisées en ce qu'**elles contiennent du polytétrafluoroéthylène (PTFE) en tant que polymère thermoplastique du composant A).

4. Pièces en matière plastique métallisées selon l'une quelconque des revendications 1 à 3, **caractérisées en ce que** la charge du composant B) est utilisée sous forme d'une poudre ayant une taille moyenne de particules dans la plage de 0,3 x 10⁻⁶ à 500 x 10⁻⁶ m et n'est pas fusible.

5. Pièces en matière plastique métallisées selon l'une quelconque des revendications 1 à 4, **caractérisées en ce qu'**elles contiennent un poly(sulfure d'arylène) oxydé en tant que charge du composant B).

6. Pièces en matière plastique métallisées selon l'une quelconque des revendications 1 à 5, **caractérisées en ce que** la métallisation contient du cuivre, de l'argent, de l'aluminium, de l'or, du titane, du fer, du chrome ou du nickel, ou des mélanges ou alliages de ceux-ci.

7. Procédé pour la fabrication de pièces en matière plastique selon l'une quelconque des revendications 1 à 6, **caractérisé en ce qu'**on prépare des mélanges à partir des composants individuels, **en ce que** les mélanges sont ensuite transformés en pièces moulées, par moulage par injection ou moulage par compression ou extrusion ou moulage par soufflage ou frittage à des températures de 150 à 450°C, de préférence de 200 à 400°C, et **en ce que** les pièces moulées sont ensuite métallisées par pulvérisation cathodique ou vaporisation.

8. Procédé selon la revendication 7, **caractérisé en ce qu'**on prépare à partir des composants individuels des mélanges dans lesquels la proportion du composant B) du mélange se situe dans la plage de 1 à 99 % en poids, de préférence dans la plage de 1 à 30 % en poids, en particulier de 1 à 20 % en poids, par rapport au poids total du mélange de polymères.

9. Procédé selon la revendication 8, **caractérisé en ce que** la proportion de B se situe dans la plage de 5 à 15 % en poids.

10. Utilisation de pièces moulées métallisées selon l'une quelconque des revendications 1 à 6, dans l'industrie de l'automobile, pour la fabrication de cadres d'instruments d'affichage et de radios, de poignées de porte, de manivelles de lève-glace, de grilles de chauffage, de boutons de tableau de bord et de réflecteurs, dans l'industrie de la radio, de la télévision et de l'électronique pour des circuits imprimés, comme porte-puces et dans des installations de protection contre les parasites et interférences par blindage, dans l'industrie dentaire et médicale, dans l'industrie optique, pour la fabrication de miroirs ainsi que pour la fabrication de jouets et d'articles ménagers.
